# FASCICULE DE BREVET EUROPEEN

(11) **EP 3 384 598 B1**
(45) Date de publication et mention de la délivrance du brevet: **01.04.2026**
(21) Numéro de dépôt: 16808956.3
(22) Date de dépôt: 30.11.2016
(51) Int. Cl.: H03F 1/56, H03F 3/195, H03F 3/24, H03F 3/60, H01P 5/12

(54) **LIGNE D'ADAPTATION, ÉTAGE ET APPAREIL D'AMPLIFICATION ET/OU DE DIVISION ASSOCIÉS**
ADAPTIONSLEITUNG UND ZUGEHÖRIGE STUFEN- UND VERSTÄRKUNGS- UND/ODER TEILUNGSVORRICHTUNG
MATCH LINE, AND ASSOCIATED STAGE AND AMPLIFICATION AND/OR DIVISION APPARATUS

(30) Priorité: 30.11.2015 FR 1502497
(43) Date de publication de la demande: 10.10.2018
(73) Titulaire: Thales, 92400 Courbevoie (FR)
(72) Inventeur: GIRARD, Dimitri, 92622 Gennevilliers Cedex (FR); FASSE, Dominique, 92622 Gennevilliers Cedex (FR); KASSAB, Quentin, 92622 Gennevilliers Cedex (FR); CHAHBAZIAN, Max, 46500 Gramat (FR); LACHATER, Laurent, 46500 Gramat (FR)
(74) Mandataire: Lavoix
(86) Numéro de dépôt international: PCT/EP2016/079289
(87) Numéro de publication internationale: WO 2017/093324

(56) Documents cités:
- EP-A2- 0 424 108
- US-A1- 2011 025 412
- US-A1- 2012 293 274
- US-A1- 2015 123 734

## Description

La présente invention concerne un appareil d'amplification ou de division radiofréquence comportant un combineur à cavité, une pluralité de premières voies et une deuxième voie, le combineur étant configuré pour recombiner les premières voies en la deuxième voie, chaque première voie comportant un amplificateur et une ligne d'adaptation.

Les grands instruments scientifiques comme les collisionneurs à particules ont besoin d'être alimentées en ondes radiofréquence pour différentes applications.

A titre d'exemple, dans les accélérateurs de particules, l'accélération se réalise avec des cavités alimentées par des fortes puissances pour des fréquences appartenant à la gamme comprise entre 10 MHz (mégaHertz) et 10 GHz (gigaHertz). Dans un tel contexte, il est entendu par « forte puissance », une puissance comprise entre 100 kiloWatts (kW) et plusieurs mégaWatts (MW).

Ainsi, pour certaines applications, il est souhaitable de disposer d'ondes radiofréquences présentant de fortes puissances.

La production de puissance élevée est obtenue à l'aide d'amplificateurs. Un amplificateur électronique est un système électronique augmentant la puissance d'un signal électrique. Il existe deux grandes familles d'amplificateurs électroniques : les amplificateurs à tubes et les amplificateurs à état solide.

Les documents US 2015/123734 A1 et US 2012/0293274 A1 présentent un dispositif d'amplification d'un signal.

Toutefois, la puissance unitaire des amplificateurs haute fréquence étant limitée, il est souvent utile de coupler (ou combiner) plusieurs amplificateurs élémentaires pour atteindre la puissance souhaitée.

Pour cela, il est connu d'utiliser des combineurs à cavité. Les combineurs à cavité sont un exemple particulier dans le domaine de la combinaison d'ondes radiofréquences. Les combineurs à cavités permettent, notamment de sommer un grand nombre d'entrées dans un seul étage de combinaison, ce qui permet de transformer une technologie basse puissance (gamme comprise entre 1 Watt et 1 kiloWatt) en une forte puissance (gamme comprise entre 100 Watts et 500 kiloWatts). Un tel type de combineur est réciproque, il permet aussi de réaliser un diviseur de puissance.

Les combineurs à cavités présentent de faibles pertes, un encombrement réduit et une puissance élevée.

Un appareil d'amplification à combineur à cavités comporte usuellement des voies avec des amplificateurs avec des transistors de forte puissance montés en push-pull.

Mais cette configuration a l'inconvénient de nécessiter un balun de puissance. Dans les agencements les plus compacts, la dissipation d'énergie dans le balun est généralement importante, ce qui entraîne une complexité et un surcoût important.

De plus, l'appareil d'amplification à combineur à cavités requiert l'emploi d'un grand nombre d'entrées en parallèle.

Toutefois, cela suppose de garantir une bonne fiabilité de fonctionnement indépendamment de l'état de chaque entrée. Par exemple, lors d'une panne d'un amplificateur, la puissance de sortie de l'appareil est à maintenir au mieux.

De fait, le rendement de l'appareil diminue lorsqu'un amplificateur tombe en panne.

Il existe donc un besoin pour un appareil d'amplification à combineur de cavités permettant de remédier au moins en partie aux inconvénients précédents.

Pour cela, il est décrit un appareil d'amplification conforme à la revendication 1.

Suivant des modes de réalisation particuliers, l'appareil d'amplification comprend une ou plusieurs des caractéristiques des revendications 2 à 6, prise(s) isolément ou suivant toutes les combinaisons techniquement possibles.

D'autres caractéristiques et avantages de l'invention apparaîtront à la lecture de la description qui suit de modes de réalisation de l'invention, donnée à titre d'exemple uniquement et en référence aux dessins qui sont :
- figure 1, une vue schématique d'un exemple d'appareil d'amplification radiofréquence,
- figure 2, une vue schématique d'un exemple de premier étage faisant partie de l'appareil de la figure 1,
- figure 3, une vue d'un schéma électrique équivalent du premier étage selon la figure 2,
- figure 4, une vue schématique d'un exemple d'amplificateur faisant partie de l'appareil de la figure 1,
- figure 5, une vue schématique d'un exemple d'une partie de premières voies et d'un combineur à cavité faisant partie de l'appareil de la figure 1,
- figure 6, un graphe présentant l'évolution temporelle de la puissance de sortie de l'appareil d'amplification conforme à la figure 5,
- figure 7, une vue schématique d'un autre exemple d'une partie de premières voies et d'un combineur à cavité faisant partie de l'appareil de la figure 1,
- figure 8, une vue d'un schéma électrique équivalent de la partie de premières voies et du combineur à cavité selon la figure 7,
- figure 9, un schéma mécanique en perspective d'une sonde différentielle sous forme d'une boucle d'insertion du combineur à cavité selon la figure 7,
- figure 10, un schéma mécanique en perspective d'un autre exemple de boucle d'insertion,
- figure 11, un schéma mécanique en perspective d'encore un autre exemple de boucle d'insertion,
- figure 12, une vue schématique d'un schéma électrique d'un autre exemple d'appareil d'amplification radiofréquence,
- figure 13, une vue schématique d'encore un autre exemple d'appareil d'amplification radiofréquence, et
- figure 14, une vue schématique d'un exemple de combineur à cavité.

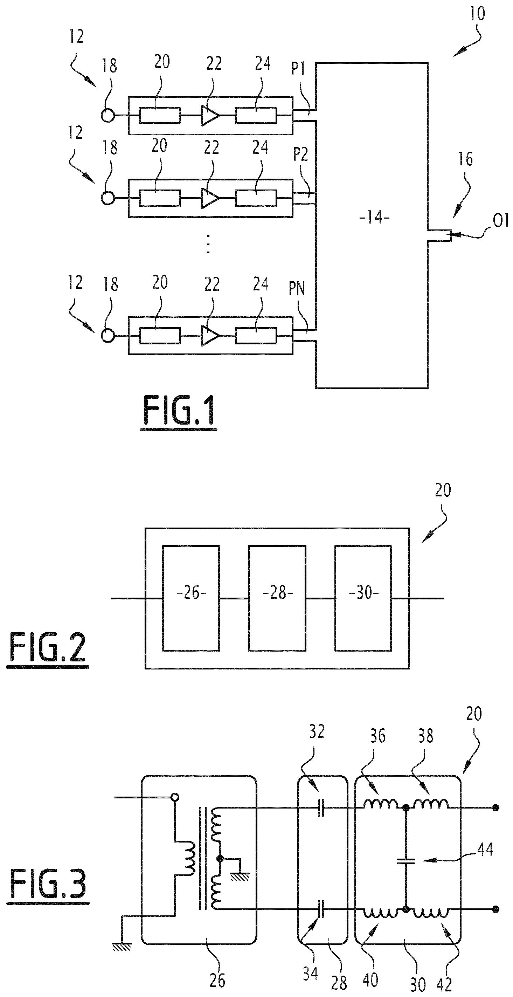

Un appareil 10 d'amplification radiofréquence est illustré à la figure 1.

L'appareil 10 comporte des premières voies 12 qui sont recombinées par un combineur 14 à cavité en une deuxième voie 16.

L'appareil 10 est propre à fonctionner à une fréquence de fonctionnement qui est la fréquence de fonctionnement du combineur 14.

Plus précisément, l'appareil 10 est propre à fonctionner pour un ensemble de bande de fréquences de fonctionnement, la bande de fréquences étant déterminée par la bande de fréquences du combineur 14.

La fréquence de fonctionnement est une fréquence de fonctionnement comprise entre 10 kHz et 300 GHz.

Cela signifie que tous les composants de l'appareil 10 sont dimensionnés pour fonctionner spécifiquement à la fréquence de fonctionnement.

En particulier, les impédances des composants sont calculées à la fréquence de fonctionnement.

En outre, selon le niveau de puissance envisagée pour l'onde radiofréquence, les composants sont de plus adaptés pour supporter une puissance importante.

Selon l'exemple de la figure 1, trois premières voies 12 sont représentées, les pointillés indiquant que le nombre de premières voies 12 est quelconque.

Le nombre de première voies 12 est supérieur à deux.

Par exemple, le nombre de premières voies 12 est supérieur à 50 voire supérieur à 100.

Dans l'exemple de la figure 1, chaque première voie 12 est identique.

Une seule première voie 12 est spécifiquement décrite dans la suite, les mêmes remarques s'appliquant aux autres premières voies 12

La première voie 12 comporte une source 18, un premier étage 20, un amplificateur 22 et un deuxième étage 24.

La source 18 est propre à alimenter la première voie 12 en ondes radiofréquences.

Par exemple, la source 18 est une source en courant.

Le premier étage 20 est un étage de basse puissance.

Le qualificatif de « basse puissance » indique que le premier étage 20 est adapté à interagir avec des ondes radiofréquences présentant une énergie inférieure aux ondes avec lesquelles le deuxième étage 24 est propre à interagir et avec lesquelles le combineur 14 est propre à interagir.

En l'occurrence, une onde est considérée comme une onde présentant une basse puissance lorsque la puissance de l'onde est comprise entre 0,1 W et 100 W.

Un exemple de premier étage 20 est illustré aux figures 2 et 3.

Le premier étage 20 comporte un balun 26, un module de découplage 28 et un adaptateur d'impédance 30.

Un balun est un circuit électrique utilisé pour effectuer la liaison entre une ligne de transmission symétrique (ligne bifilaire ou lignes imprimées parallèles) et une ligne de transmission asymétrique (câble coaxial ou ligne imprimée au-dessus d'un plan de masse).

Un balun est, par exemple, réalisé à l'aide de câble coaxial enroulé ou d'une petite section de ligne bifilaire bobinée sur un tore en ferrite.

Un tel mode de réalisation est schématiquement illustré par la figure 3.

Le module de découplage 28 est propre à réaliser un découplage de type DC (acronyme de « direct current » en anglais qui signifie « courant continu »).

Selon l'exemple illustré, le module de découplage 28 comporte des condensateurs 32 et 34.

L'adaptateur d'impédance 30 assure une adaptation de l'impédance entre l'impédance du balun 26 et du module de découplage 28 par rapport à l'impédance de l'amplificateur 22.

Par exemple, comme illustré, l'adaptateur d'impédance 30 est câble un coaxial.

Le schéma électrique équivalent est une ligne à éléments discrets, c'est-à-dire un dipôle comprenant des inductances 36, 38, 40, 42 et un condensateur 44. Les inductances 36, 38, 40, 42 sont agencées sous forme d'un pont de Wheatstone relié par un condensateur 44.

L'amplificateur 22 est propre à amplifier une onde incidente en une onde émergente présentant une énergie plus importante que l'onde incidente.

L'amplificateur 22 est, par exemple, un montage en configuration dite « push-pull ». Un tel montage utilise une paire de composants actifs qui fournissent ou absorbe en alternance du courant à ou d'une charge.

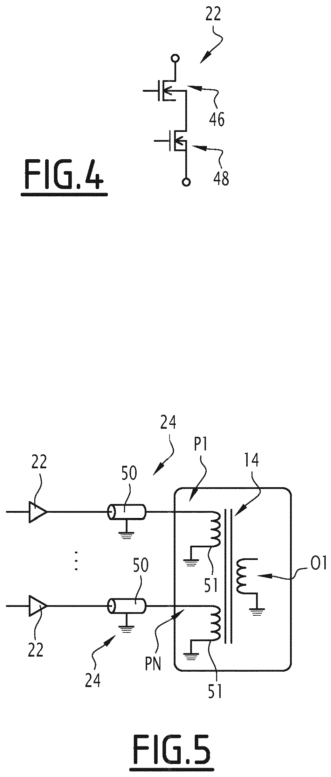

En l'occurrence, comme illustré à la figure 4, l'amplificateur 22 est un montage de deux transistors 46 et 48 en configuration dite « push-pull ». Cette configuration permet d'avoir des puces compactes et de forte puissance.

Selon le mode de réalisation illustré, chaque transistor 46 et 48 est un transistor durci. Il est entendu par le terme « durci » dans ce contexte que chaque transistor 46 et 48 est protégé des ondes réfléchies. Il en résulte que chaque transistor 46 et 48 présente une certaine robustesse pour résister à des courts-circuits durant plusieurs millisecondes.

Le deuxième étage 24 est un étage de moyenne puissance.

Le qualificatif de « moyenne puissance » indique que le deuxième étage 24 est adapté à interagir avec des ondes radiofréquences présentant une énergie supérieure aux ondes avec lesquelles le premier étage 20 mais présentant une énergie inférieure à l'énergie aux ondes avec lesquelles le combineur 14 est propre à interagir.

En l'occurrence, une onde est considérée comme une onde présentant une moyenne puissance lorsque la puissance de l'onde est comprise entre 100 W et 1 kW.

Chaque composant du deuxième étage 24 est adapté à interagir avec une onde présentant une moyenne puissance lorsque la puissance de l'onde est comprise entre 100 W et 1 kW.

Le deuxième étage 24 est propre à assurer l'interfaçage entre l'amplificateur 22 et la cavité 14.

Selon l'exemple particulier de la figure 5, le deuxième étage 24 comporte une ligne d'adaptation 50 reliant l'amplificateur 22 au combineur 14.

La ligne d'adaptation 50 présente une première extrémité reliée à l'amplificateur 22 et une deuxième extrémité reliée au combineur 14.

La première extrémité est adaptée en impédance à l'impédance de l'amplificateur 22.

La deuxième extrémité est adaptée en impédance à l'impédance du combineur 14.

L'impédance de la ligne d'adaptation 50 est la différence d'adaptation entre l'impédance de la première extrémité et l'impédance de la deuxième extrémité aux pertes par effet de peau près.

L'impédance de la ligne d'adaptation 50 est supérieure au rapport entre la longueur d'onde associée à la fréquence propre et le chiffre 8.

Selon un mode de réalisation, l'impédance de la ligne d'adaptation est égale au rapport entre la longueur d'onde associée à la fréquence propre et le chiffre 8 à 10% près.

En variante, la ligne d'adaptation 50 présente une impédance égale au rapport entre la longueur d'onde associée à la fréquence propre et le chiffre 8 à 5% près.

Selon un mode de réalisation, la ligne d'adaptation 50 présente une impédance égale au rapport entre la longueur d'onde associée à la fréquence de fonctionnement et le chiffre 8.

Par exemple, selon le mode de réalisation illustré, la ligne d'adaptation 50 est un coaxe ayant une longueur égale au rapport entre la longueur d'onde associée à la fréquence de fonctionnement et le chiffre 8.

Selon un autre mode de réalisation, la ligne d'adaptation 50 est une ligne conductrice aussi appelée sous la dénomination anglaise de « stripline ».

Selon un autre mode de réalisation, la ligne d'adaptation 50 est un guide d'ondes.

Selon encore un autre mode de réalisation, la ligne d'adaptation 50 comporte des composants comme des inductances et des condensateurs.

Le deuxième étage 24 est dépourvu de circulateur et d'isolateur.

Le combineur 14 comporte une pluralité de premiers ports P1, P2 ... PN et un deuxième port O1.

Le combineur 14 est propre à sommer les ondes radiofréquences de moyenne puissance introduites dans chacun des premiers ports P1, P2 ... PN pour générer une onde de forte puissance (entre 10 kW et 200 kW) sur le deuxième port O1.

Selon les cas, le combineur 14 est adapté à fonctionner avec des modes de résonance d'une cavité. Le combineur 14 est à fonctionner en effectuant une sommation en tension ou en courant.

Lorsque le combineur 14 fonctionne sur un mode TM010, le champ magnétique est maximum au niveau des parois du combineur 14 et le champ électrique est maximum au centre du combineur 14. La puissance est injectée par des boucles d'insertion présentes sur la paroi et prélevé par une sonde de tension au centre.

Pour la suite, à titre d'illustration, il est supposé que le combineur 14 est un combineur fonctionnant avec une résonance en mode TM010.

Cela signifie que le combineur 14 est adapté à interagir avec une onde présentant une moyenne puissance lorsque la puissance de l'onde est comprise entre 10 kW et 200 kW. Cette adaptation s'applique à tous les composants du combineur 14.

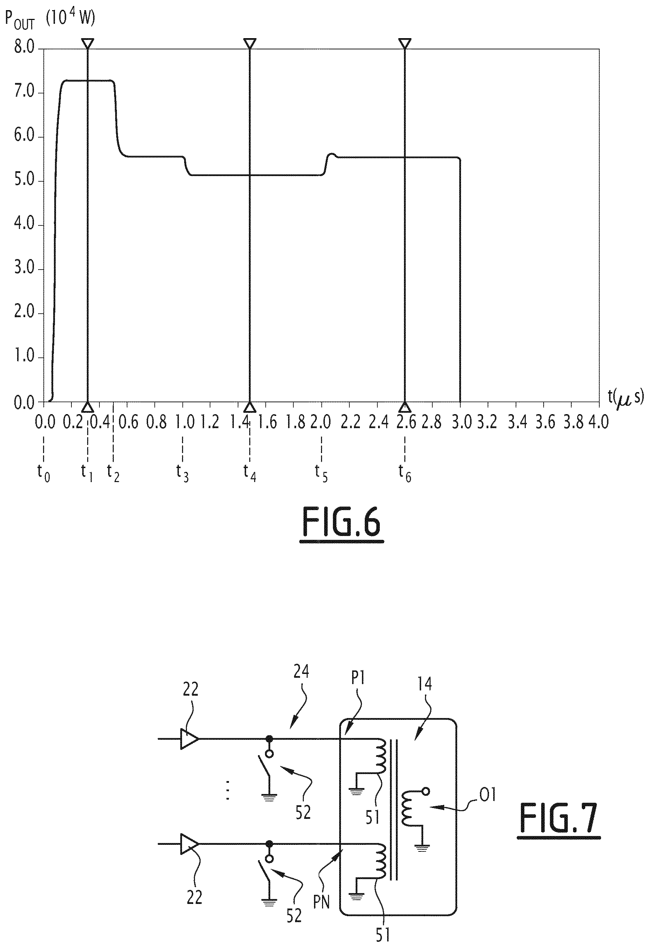

Le fonctionnement de l'appareil 10 en présence de dysfonctionnement est maintenant décrit en référence à la figure 6.

Les résultats pour un combineur 14 présentant une fréquence de fonctionnement à 200 MHz avec 80 premiers ports et une ligne d'adaptation 50 sont visibles sur la simulation de la figure 6.

Il est ainsi vérifié l'intérêt de la ligne d'adaptation 50 qui permet de largement limiter la diminution de puissance et donc la désadaptation de la cavité et de tous les amplificateurs 22.

A un instant initial t0 correspondant au début de la simulation, chacun des 80 premiers ports transmettent leur puissance au deuxième port O1.

Il est constaté à un premier instant t1 (à 300 µs) que la puissance au port combiné s'élève Pout = 72,7 kW pour 80*0,93=74,4 kW en entrée, ce qui correspond à une perte de seulement 0,1 dB.

A un deuxième instant t2, 500 ns après l'instant initial t0, les 16 premiers ports sont désactivées en ouvrant le circuit.

Il est constaté que la puissance au deuxième port O1 s'élève à Pout = 55,5 kW pour 59,7 kW en entrée.

A un troisième instant t3, 1 µs après l'instant initial t0, l'impédance des transistors 46 et 48 est ramenée sur les 16 premiers ports en même temps.

Il est constaté que la puissance au deuxième port O1 diminue un peu (à 51,47 kW) car les 16 amplificateurs 22 non détruits absorbent de la puissance radiofréquence (environ 225 W par transistor 46 et 48). Ceci correspond à une perte de 0,63 dB (voir quatrième instant t4 à 1,5 µs environ).

A un cinquième instant t5, 2 µs après l'instant initial t0, les 16 premiers ports sont court-circuitées en même temps.

Il est constaté que la puissance au deuxième port O1 revient à un niveau nominal de 55,6 kW pour 64*0,93=59,7 kW en entrée (voir sixième instant t6 à 2,5 µs environ). Ceci correspond à une perte de 0,31 dB.

Il apparaît ainsi que la ligne d'adaptation 50 permet au combinateur 14 de voir une impédance quasi identique sur l'ensemble des premiers ports P1 à PN.

Le bon dimensionnement de la ligne d'adaptation 50 permet d'isoler le combineur 14 de chaque amplificateur 22.

La ligne d'adaptation 50 est dimensionnée pour que le combineur 14 voit toujours à peu près la même impédance indépendamment de l'état de chaque amplificateur 22.

Autrement formulé, quand un amplificateur 22 tombe en panne, le fonctionnement du combineur 14 n'est pas modifié.

Une telle configuration permet de maintenir le rendement du combineur 14 quasi constant sans prendre en compte le nombre d'amplificateurs 22 actifs.

Par définition le rendement du combineur 14 est défini par le rapport entre la puissance sur le deuxième port O1 sur la somme des puissances sur chacun des premiers ports P1 à PN.

Cela permet de remplacer un isolateur (c'est-à-dire un ensemble de circulateur et d'une résistance d'adaptation) de l'état de la technique par la ligne d'adaptation 50.

Il en résulte une réduction des coûts.

De plus, le rendement est optimisé.

La figure 7 illustre un autre exemple de deuxième étage 24. Les éléments identiques au mode de réalisation de la figure 5 ne sont pas décrits à nouveau. Seules les différences sont mises en évidence.

La ligne d'impédance 50 est remplacée par un circuit de commutation 52.

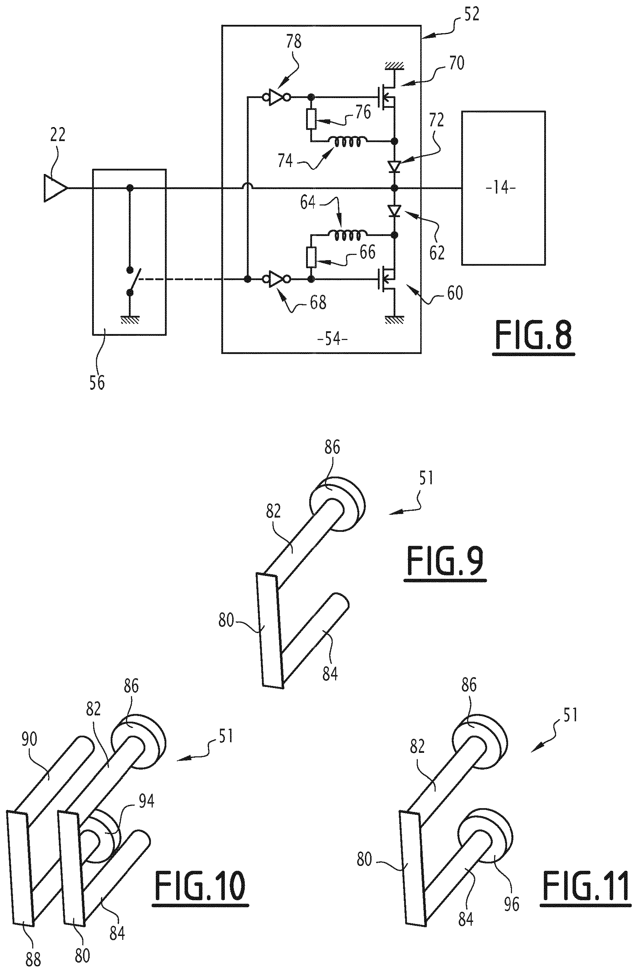

Un exemple de circuit de commutation 52 est détaillé à la figure 8.

Le circuit de commutation 52 comprend un premier commutateur 54 et un deuxième commutateur 56.

Le premier commutateur 54 présente un premier temps de commutation.

Le premier commutateur 54 est un commutateur rapide ce qui signifie que le premier temps de commutation est compris entre 10 nanosecondes (ns) et 1 milliseconde (ms).

Le premier commutateur 54 est propre à commander le deuxième commutateur 52 en émettant un signal de sortie.

Le premier commutateur 54 est un circuit électronique comportant des diodes PIN. Une diode PIN (acronyme anglais pour « Positive Intrinsic Negative diode » ce qui se traduit par diode positive intrinsèque négative en français) est une diode constituée d'une zone non-dopée, dite intrinsèque I, intercalée entre deux zones dopées P et N.

Plus précisément, le premier commutateur 54 comporte des transistors et des diodes PIN.

Dans le cas particulier représenté, le premier commutateur 54 comporte deux montages reliés ensemble et identiques.

Le premier montage permet de commuter en présence d'une alternance positive tandis que le deuxième montage permet de commuter en présence d'une alternance négative.

Le premier montage est un transistor 60 dont une borne est reliée à la masse, une autre borne est reliée à la cathode d'une diode 62 et à un ensemble d'une inductance 64 et d'une résistance 66 et une autre borne est reliée à une diode 64 et à la résistance 66.

Selon l'exemple, le transistor 60 est un transistor à effet de champ à grille isolée plus couramment nommé MOSFET (acronyme anglais de « Metal Oxide Semiconductor Field Effect Transistor » - qui se traduit par » transistor à effet de champ à structure métal-oxyde-semiconducteur »).

Similairement le deuxième montage est un transistor 70 dont une borne est reliée à la masse, une autre borne est reliée à l'anode d'une diode 72 et à un ensemble d'une inductance 74 et d'une résistance 76 et une autre borne est reliée à une diode 78 et à la résistance 76.

Le deuxième commutateur 56 est un relais électromécanique.

Le relais électromécanique est propre à fonctionner selon deux positions, une position fermée dans laquelle l'amplificateur 22 est relié à la cavité 14 et une position ouverte dans laquelle l'amplificateur 22 n'est pas relié à la cavité 14.

Le temps de commutation du deuxième commutateur 56 est inférieure à moitié du premier temps de commutation. Le temps de commutation du deuxième commutateur 56 est appelé deuxième temps de commutation.

Le deuxième temps de commutation est supérieur à 1 ms.

Le deuxième commutateur 56 est un commutateur de sécurité.

Le fonctionnement de l'appareil 10 selon la figure 7 est maintenant décrit.

Le deuxième commutateur 56 est normalement fermé.

Plus précisément, le deuxième commutateur 56 est en état de court-circuit lorsque le deuxième commutateur 56 est alimenté par un signal de sortie nul.

Dès que le signal de sortie n'est plus nul, le deuxième commutateur 56 est ouvert pour permettre le fonctionnement de l'appareil 10.

Le circuit de commutation 52 permet la mise en sécurité et la mise hors tension d'un amplificateur 22 couplé à un combineur 14 par réalisation d'un court-circuit.

Le court-circuit est réalisé par une commutation à la masse.

Dans le cas d'une injection de puissance en champ magnétique dans un combineur 14, si une boucle est mise à la masse, l'impédance de la boucle devient fortement réactive.

Par conséquent, la boucle ne consomme pas de puissance. De plus, la boucle ne change pas le fonctionnement de la cavité, l'impédance de la cavité étant conservée. Seule la résistance de court-circuit de quelques milli-ohms amène des pertes dans le combineur 14.

Dans le cas d'une injection en champ électrique, le circuit de commutation ouvre la boucle de sorte que la boucle présente une haute impédance. Il est aussi à noter que, pour une cavité avec une injection en tension, une ouverture de circuit est réalisée.

De ce fait, le circuit de commutation 52 a un temps de transition inférieur au temps de réaction du combineur 14.

Par conséquent, le circuit de commutation 52 remplace un circulateur.

La présence d'un circulateur est donc supprimée.

De plus, le circuit de commutation permet de mettre l'amplificateur hors tension sans couper l'ensemble de l'appareil 10.

D'une part, cela permet de ne pas détériorer davantage l'amplificateur 22 en panne. De fait, avec un court-circuit, aucune puissance radiofréquence n'est renvoyée sur un transistor 46, 48 de l'amplificateur 22.

D'autre part, cela facilite la maintenance puisque cela permet de déconnecter et de remplacer l'amplificateur 22 en panne sans interrompre le fonctionnement de l'appareil 10.

Il en résulte une réduction des coûts et une optimisation du rendement.

La figure 9 présente un schéma mécanique en perspective d'une sonde différentielle sous forme d'une boucle d'insertion 51 du combineur 14 selon la figure 7.

Dans certaines terminologie, la boucle d'insertion est également appelée un coupleur.

Dans cette représentation, la boucle d'insertion 51 comporte une tige de connexion 80 reliée à deux tiges de conduction 82 et 84. Dans ce cas, la boucle d'insertion 51 comporte, en outre, une entrée en tension 86. La première tige de conduction 82 est reliée à l'entrée en tension 86 tandis que la deuxième tige de conduction 84 est reliée à la masse.

Le schéma électrique équivalent de la boucle d'insertion 51 est une inductance reliée d'une part à l'entrée de tension et d'autre part à la masse.

Il est proposé, en référence, aux figures 10 et 11, une boucle d'insertion 51 à entrées différentielles.

Par entrées différentielles, il est entendu qu'une entrée est déphasée de 180° par rapport à une autre entrée. Ce déphasage est réalisé avant la boucle d'insertion 51

Une telle boucle d'insertion 51 comporte au moins deux tiges de conduction reliées chacune à une entrée distincte.

Selon le mode de réalisation de la figure 10, la boucle d'insertion 51 comporte les mêmes éléments que la boucle d'insertion 51 de la figure 9. Dans ce cas particulier, par commodité de nommage, tous les éléments sont qualifiés d'éléments primaires par contraste avec les éléments qui sont ajoutés qui sont qualifiés d'éléments secondaires.

La boucle d'insertion 51 comporte, en outre, une tige de connexion secondaire 88, reliée à deux tiges de conduction secondaires 90 et 92. Dans ce cas, la boucle d'insertion 51 comporte, en outre, une entrée en tension secondaire 86 distincte de l'entrée en tension primaire 86. La première tige de conduction secondaire 82 est reliée à la masse tandis que la deuxième tige de conduction secondaire 84 est reliée à la deuxième entrée en tension secondaire 86.

Selon le mode de réalisation de la figure 10, la boucle d'insertion 51 comporte les mêmes éléments que la boucle d'insertion 51 de la figure 9.

La boucle d'insertion 51 comporte en outre une deuxième entrée en tension 96 distincte de la première entrée en tension 86.

La deuxième tige de conduction 84 est reliée à la deuxième entrée en tension 96.

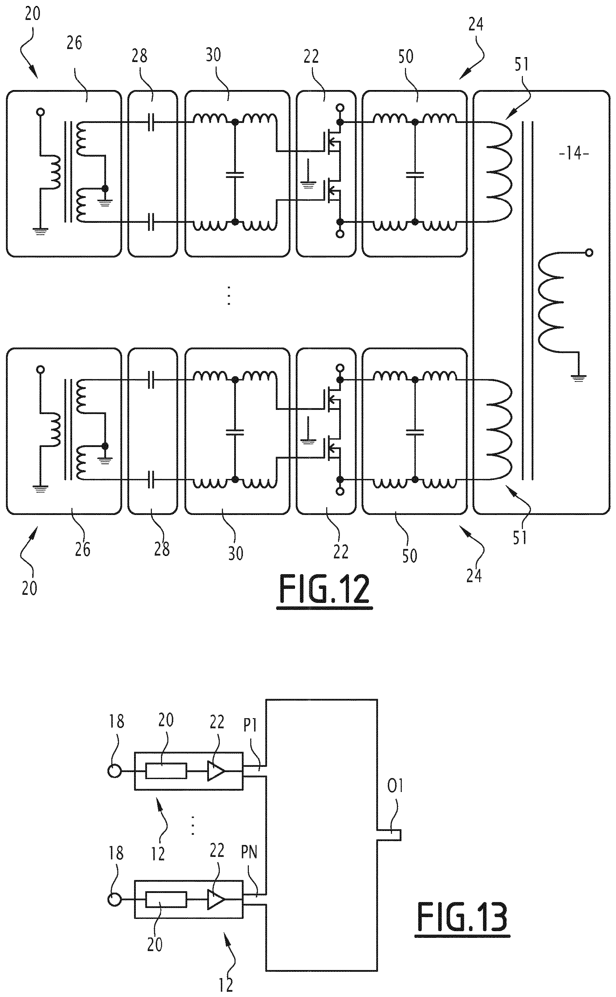

Le fonctionnement de la boucle d'insertion 51 est illustrée en référence à la figure 12 qui illustre un appareil 10 selon le mode de réalisation de la figure 5 dans lequel une boucle d'insertion 51 conforme au mode de réalisation de la figure 11 est utilisée.

Dans ce cas, la tension de sortie de la chaque voie 12 est accessible à la boucle d'insertion 51 par différence entre les deux entrées 86 et 96, de sorte que le fonctionnement de l'appareil 10 est comparable au fonctionnement d'un appareil 10 selon l'état de la technique.

Similairement, dans le cas de la boucle d'insertion 51 de la figure 10, la tension de sortie de la chaque voie 12 est accessible à la boucle d'insertion 51 par différence entre les deux entrées 86 et 94.

La boucle d'insertion 51 joue bien le rôle d'un coupleur d'entrée pour le combineur 14.

Une telle boucle d'insertion 51 supprime le besoin d'un balun dans le deuxième étage 24.

Le mode de réalisation de boucle d'insertion 51 selon la figure 11 permet également de supprimer le besoin d'un module de découplage dans le deuxième étage 24.

Dans tous les cas, la fonction de balun est déportée à l'intérieur de la cavité 14.

Il en résulte que la première voie 12 peut être réalisée sur un circuit imprimé avec un substrat usuel au lieu d'un substrat pouvant supporter des ondes radiofréquences de forte puissance.

De plus, une telle boucle d'insertion 51 permet de doubler le nombre de boucles d'insertion 51 dans la cavité 14. Ceci permet d'ajuster le coefficient de qualité et donc de diminuer le temps de montée de l'appareil 10.

Par conséquent, la fiabilité et le rendement de l'appareil 10 sont augmentés.

Dans les modes de réalisation présentés, le premier étage 20, l'amplificateur 22 et le deuxième étage 22 font partie de la même carte usuellement appelée « carte amplificatrice ».

Une telle carte est propre à être branchée sur un port de combineur 14.

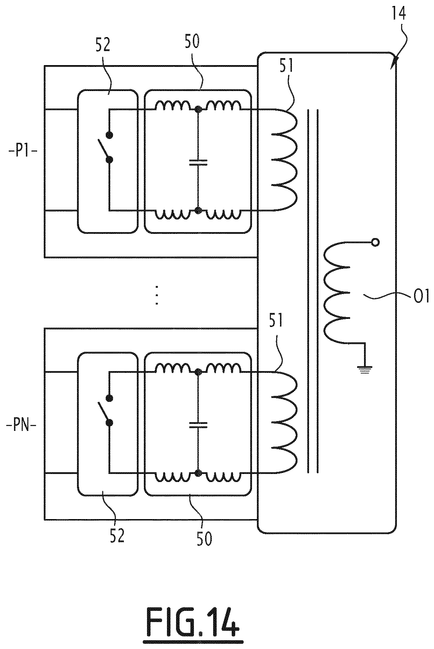

Les modes de réalisation des figures 13 et 14 illustrent le cas où la carte amplificatrice comprend uniquement le premier étage 20, l'amplificateur 22 et pas le deuxième étage 22.

Dans ces modes de réalisations, le deuxième étage 22 est intégré dans chaque premier port P1 à PN.

Les cartes amplificatrices se branchent directement sur chaque port et ne comporte pas de deuxième étage 22.

Cela rend la fabrication des cartes amplificatrices plus aisée.

Selon le cas particulier de la figure 14, il est à noter que chaque premier port P1 à PN comporte une boucle d'insertion 51 conforme à la figure 11, une ligne d'impédance 50 et un circuit de commutation 52.

De tels premiers ports P1 à PN cumulent donc les avantages de chacun des composants précités.

L'ensemble des modes de réalisations présentés permettent de réaliser une amplification de forte puissance propre à concurrencer les autres technologies d'amplification.

De fait, l'appareil 10 permet d'obtenir une plus grande puissance volumique limitée et de limiter le coût.

De plus, il est proposé de coupler un maximum de fonction dans un même équipement, ce qui améliore la compacité de l'appareil 10.

La maintenance de l'appareil 10 est aussi facilitée.

De plus, l'appareil 10 présente une fiabilité améliorée.

En outre, les performances de l'appareil 10 que sont le rendement, la largeur de la bande passante, la linéarité, le temps de montée sont meilleures que dans l'état de la technique.

Il en résulte que l'appareil 10 est mieux adapté à un fonctionnement en continu et sans interruption.

De manière générale, les modes de réalisations proposés permettent d'obtenir des appareils d'amplification forte puissance à des coûts moindres.

Le domaine de fréquences envisagé pour l'appareil 10 recouvre la gamme de quelques dizaines de mégahertz jusqu'aux limites technologiques actuelles, soit plus de la centaine de gigahertz.

L'appareil 10 est utilisable pour de nombreuses applications. En particulier, l'appareil 10 est avantageusement utilisé dans de grands instruments scientifiques, dans une cavité accélératrice et dans le domaine des télécommunications.

De plus, l'appareil 10 est également réversible puisqu'il est utilisable en appareil de division de radiofréquence. Dans ce cas, le deuxième port O sert d'entrée et les premiers ports P1 à PN servent de sortie. De plus, la sonde différentielle 51 interagit avec des sorties en tension.

Il est à noter que l'expression « sonde différentielle » désigne une sonde comportant une boucle d'insertion 51 et au moins deux entrées/sorties 86, 96. En particulier, l'expression « sonde différentielle » désigne une sonde dont deux entrées/sorties sont déphasées de 180° l'une par rapport à l'autre.

Selon le mode de réalisation de la figure 10, la sonde différentielle 51 comporte deux paires de tiges de conduction 82, 84, 90, 92. Une tige de conduction 82, 92 de chaque paire est reliée à une entrée en tension 86, 96 correspondante.

Selon le mode de réalisation de la figure 11, la sonde différentielle 51 comporte une seule paire de tiges de conduction 82, 84, chaque tige de conduction 82, 84 étant reliée à une entrée en tension 86, 96 correspondante.

Le déphasage est réalisé avant la boucle d'insertion 51, par exemple au niveau d'une entrée en tension 86, 96. Il est à noter que le déphasage de 180° n'est pas nécessairement réalisé par une seule entrée en tension 86, 96. Par exemple, chaque entrée en tension 86, 96 réalise un déphasage, la somme des deux déphasages étant égale à 180°.

## Revendications

1. Appareil (10) d'amplification ou de division radiofréquence comportant un combineur à cavité (14), une pluralité de premières voies (12) et une deuxième voie (16), le combineur étant configuré pour recombiner les premières voies (12) en la deuxième voie, chaque première voie (12) comportant un amplificateur et une ligne d'adaptation (50) pour combineur à cavité radiofréquence, la ligne d'adaptation (50) étant adaptée pour une fréquence de fonctionnement comprise entre 10 kHz et 300 GHz, la ligne d'adaptation (50) reliant l'amplificateur au combineur à cavité, la ligne d'adaptation présentant une impédance égale ou supérieure à l'impédance d'un coaxe ayant une longueur égale au rapport entre la longueur d'onde associée à la fréquence de fonctionnement et le chiffre 8,
chaque première voie (12) comportant un étage (24) de moyenne puissance pour combineur à cavité radiofréquence, l'étage de moyenne puissance reliant l'amplificateur au combineur à cavité, l'étage (24) comportant la ligne d'adaptation (50),
le combineur à cavité comporte une pluralité de premiers ports (P1, P2, PN) et un deuxième port (O1),
**caractérisé en ce que** l'étage (24) de moyenne puissance comporte en outre un circuit de commutation (52), le circuit de commutation (52) étant apte à réaliser un court-circuit par une commutation à la masse, l'étage (24) étant dépourvu de circulateur, chaque premier port (P1, P2, PN) comporte une boucle d'insertion (51).

2. Appareil (10) d'amplification ou de division radiofréquence selon la revendication 1, dans lequel la ligne d'adaptation (50) présente une impédance égale à l'impédance d'un coaxe ayant une longueur égale au rapport entre la longueur d'onde associée à la fréquence de fonctionnement et le chiffre 8 à 10% près.

3. Appareil (10) d'amplification ou de division radiofréquence selon la revendication 1 ou 2, dans lequel la ligne d'adaptation (50) présente une impédance égale à l'impédance d'un coaxe ayant une longueur égale au rapport entre la longueur d'onde associée à la fréquence de fonctionnement et le chiffre 8.

4. Appareil (10) d'amplification ou de division radiofréquence selon l'une quelconque des revendications 1 à 3, dans lequel la ligne d'adaptation (50) est un câble coaxial.

5. Appareil (10) d'amplification ou de division radiofréquence selon l'une quelconque des revendications 1 à 4, dans lequel l'étage (24) est dépourvu d'isolateur.

6. Appareil (10) d'amplification ou de division radiofréquence selon l'une quelconque des revendications 1 à 5, dans lequel l'étage (24) est adapté pour des ondes radiofréquences présentant une puissance comprise entre 100 W et 1kW.

## Patentansprüche

1. Hochfrequenzverstärkungs- oder -teilungsvorrichtung (10), umfassend einen Hohlraumkombinator (14), eine Vielzahl von ersten Kanälen (12) und einen zweiten Kanal (16), wobei der Kombinator konfiguriert ist, um die ersten Kanäle (12) wieder in den zweiten Kanal zu kombinieren, jeder erste Kanal (12) umfassend einen Verstärker und eine Anpassungsleitung (50) für Hochfrequenz-Hohlraumkombinator, die Anpassungsleitung (50) für eine Betriebsfrequenz angepasst ist, die zwischen 10 kHz und 300 GHz liegt, die Anpassungsleitung (50) den Verstärker mit dem Hohlraumkombinator verbindet, die Anpassungsleitung eine Impedanz aufweist, die gleich wie oder größer als die Impedanz eines Koaxialkabels ist, das eine Länge gleich wie das Verhältnis zwischen der mit der Betriebsfrequenz verbundenen Wellenlänge und der Ziffer 8 aufweist,
jeder erste Kanal (12) umfassend eine Mittelleistungsstufe (24) für einen Hochfrequenz-Hohlraumkombinator, wobei die Mittelstufe den Verstärker mit dem Hohlraumkombinator verbindet, die Stufe (24) umfassend die Anpassungsleitung (50),
wobei der Hohlraumkombinator eine Vielzahl von ersten Anschlüssen (P1, P2, PN) und einen zweiten Anschluss (O1) umfasst,
**dadurch gekennzeichnet, dass** die Mittelleistungsstufe (24) ferner einen Schaltkreis (52) umfasst, wobei der Schaltkreis (52) geeignet ist, um durch Schalten auf Masse einen Kurzschluss zu realisieren, der Stufe (24) ein Zirkulator fehlt, jeder erste Anschluss (P1, P2, PN) eine Einfügungsschleife (51) umfasst.

2. Hochfrequenzverstärkungs- oder -teilungsvorrichtung (10) nach Anspruch 1, wobei die Anpassungsleitung (50) eine Impedanz aufweist, die der Impedanz eines Koaxialkabels entspricht, dessen Länge dem Verhältnis zwischen der mit der Betriebsfrequenz verbundenen Wellenlänge und der Zahl 8 entspricht, mit einer Genauigkeit von 10 %.

3. Hochfrequenzverstärkungs- oder -teilungsvorrichtung (10) nach Anspruch 1 oder 2, wobei die Anpassungsleitung (50) eine Impedanz aufweist, die der Impedanz eines Koaxialkabels mit einer Länge entspricht, die dem Verhältnis zwischen der mit der Betriebsfrequenz verbundenen Wellenlänge und der Zahl 8 entspricht.

4. Hochfrequenzverstärkungs- oder -teilungsvorrichtung (10) nach einem der Ansprüche 1 bis 3, wobei die Anpassungsleitung (50) ein Koaxialkabel ist.

5. Hochfrequenzverstärkungs- oder -teilungsvorrichtung (10) nach einem der Ansprüche 1 bis 4, wobei der Stufe (24) ein Isolator fehlt.

6. Hochfrequenzverstärkungs- oder -teilungsvorrichtung (10) nach einem der Ansprüche 1 bis 5, wobei die Stufe (24) für Hochfrequenzwellen angepasst ist, die eine Leistung zwischen 100 W und 1 kW aufweisen.

## Claims

1. Radio frequency amplification or division apparatus (10) comprising a cavity combiner (14), a plurality of first channels (12) and a second channel (16), the combiner being configured to combine the first channels (12) into the second channel, each first channel (12) comprising an amplifier and a match line (50) for a radio frequency cavity combiner, the match line (50) being adapted for an operating frequency of between 10 kHz and 300 GHz, the match line (50) connecting the amplifier to the cavity combiner, the match line having an impedance equal to or greater than the impedance of a coax with a length equal to the ratio between the wavelength associated with the operating frequency and the number 8,
each first channel (12) comprising a medium-power stage (24) for a radio frequency cavity combiner, the medium-power stage connecting the amplifier to the cavity combiner, the stage (24) comprising the match line (50),
the cavity combiner comprises a plurality of first ports (P1, P2, PN) and a second port (O1),
**characterised in that** the medium-power stage (24) also comprises a switching circuit (52), the switching circuit (52) being capable of producing a short-circuit by ground switching, the stage (24) having no circulator, each first port (P1, P2, PN) comprises an insertion loop (51).

2. Radio frequency amplification or division apparatus (10) according to claim 1, in which the match line (50) has an impedance equal to the impedance of a coax with a length equal to the ratio between the wavelength associated with the operating frequency and the number 8, to within 10%.

3. Radio frequency amplification or division apparatus (10) according to claim 1 or 2, in which the match line (50) has an impedance equal to the impedance of a coax with a length equal to the ratio between the wavelength associated with the operating frequency and the number 8.

4. Radio frequency amplification or division apparatus (10) according to any one of claims 1 to 3, wherein the match line (50) is a coaxial cable.

5. Radio frequency amplification or division apparatus (10) according to any one of claims 1 to 4, in which the stage (24) has no isolator.

6. Radio frequency amplification or division apparatus (10) according to any one of claims 1 to 5, in which the stage (24) is adapted for radio frequency waves with a power of between 100 W and 1 kW.
